# EUROPEAN PATENT APPLICATION

(11) **EP 2 674 790 A1**
(43) Date of publication of application: **18.12.2013**
(21) Application number: 13171959.3
(22) Date of filing: 14.06.2013
(51) Int. Cl.: G01V 3/08

(54) **Device, system and method for metal detection**

(30) Priority: 15.06.2012 ES 201230945
(71) Applicant: Matinsa Proyectos e Instalaciones Industriales, S.L., 43140 La Pobla de Mafumet (Tarragona) (ES)
(72) Inventor: Garces Cadenas, Javier, 43140 La Pobla de Mafumet (Tarragona) (ES); Marti Rovirosa, Xavier, 43140 La Pobla de Mafumet (Tarragona) (ES)
(74) Representative: Pons Ariño, Angel

(57) **Abstract**

A metal detection device is described which enables, by means of a module for determining the variation in the magnetic field, the determination, in accordance with the variations in the magnetic field, of the nearby presence of metallic materials based on the interference produced by said presence in the magnetic field that surrounds the device described herein.

## Description

### OBJECT OF THE INVENTION

The present invention falls within the field of metal detection devices.

The object of the invention consists of a device, a system having several devices such as that mentioned and a metal detection method that is capable of detecting the presence of metals therearound, said detection being based on variations in the magnetic field.

### BACKGROUND OF THE INVENTION

In the state of the art, metal detection devices are known to exist which, by means of a series of electromagnetic impulses, are capable of detecting metallic objects, such as the systems based on this principle used by metal detector arches.

Said devices only detect the presence of metals within their scope of action, due to which the detection methodology they use is based on the aforementioned magnetic impulses. Conventional detectors work in two different ways: one based on the variation in frequency on introducing the metal in a high-frequency magnetic field and the other based on the distortion of the high-frequency magnetic field on introducing a metallic object. These detectors consist of two coils, one that creates the high-frequency field and another that detects changes in said field.

Therefore, in the prior art there are documents that make reference to metal detectors, such as for example ES-1020719_U, which discloses a metal detector arch having a double portal, **characterised in that** it has a second receiver panel disposed on the opposite side of the transmitter panel, forming a double portal with a transmitter panel in the middle and, on either side, another two completely independent receiver panels, all of which can be integrated in the extended control, if any, which are controlled through a central panel having an acoustic and optical indicator that indicates the alarm level selected and the signal level detected, having programme and sensitivity selectors, and in that the aforementioned double portal has methods for annulling interferences or signals not emitted by its own transmitter.

ES-2021544 discloses a ferromagnetic metal detector which discriminates metals by shape and is intended mainly for use in establishments or places, such as banks or customs, where firearm detection is required, to which end the users of said services walk between the detector, which consists of a pair of transmitter coils and receiver coils, in such a manner that the transmitter coils are connected to an impulse generator, creating a magnetic spectrum that determines the height and width of the object, while a second pair of transmitter coils wherebetween a receiver coil is disposed, said transmitter coils being connected to an impulse generator, create a magnetic spectrum that determines the length of the object in the direction of passage of the user through the detector.

### DESCRIPTION OF THE INVENTION

One aspect of the invention consists of a device for detecting metallic materials, the basic configuration of which includes a preferably cylindrical casing made of a material that does not alter or affect the magnetic fields, i.e. it does not act as a magnetic shield, for example; a PCB is disposed in said casing, wherein a circuit is defined which in its minimum configuration comprises a module for determining the position of the variation of the magnetic field, a compass that can be of the digital type, a module for monitoring said position and an integrated programme adapted to capture the data generated by the digital compass; obviously, the module for determining the magnetic field or the module for determining the variation in the magnetic field may have means for converting the position into data relating to said position or information relating thereto which allows other programmable devices, such as those of the monitoring module, to process and understand said data. Said means are already included in the case of the digital compass. Said variation in the magnetic field is determined with respect to an initial magnetic field wherein the device for detecting metallic materials is disposed, considering variation to be any change therein.

Logically, said data must be processed. A preferred embodiment of the described device comprises data transmission means, which can be cable-based or wireless, for sending said data to a central processing unit where said data is received and processed to determine interferences in the magnetic field determined on the basis of the aforementioned variation in the magnetic field.

In order for the foregoing to function, there are also means for supplying electric current which can be defined by an autonomous battery incorporated in the device itself or, in the case of the cable-based solution, for supplying power to the device.

In an alternative embodiment of the device described herein, all of the elements (except for the battery or the means for supplying electric current) can be efficiently integrated in a chip, as current technology enables the integration of circuits and elements such as those described in a single chip.

Another aspect of the invention is a metal detection system consisting of several interconnected devices. In this case, said devices can be interconnected using 485-type bus cable and the battery or means for supplying electric current can be disposed connected to the first or last device.

Lastly, another aspect of the invention is the metal detection method using the device or system described, as inferred from the description of the device itself; the detection method is based on positioning the device and allowing the module for determining the magnetic field intended for indicating a variation in the magnetic field to establish said position while the determining module collects data from said module to determine the magnetic field. Said data is sent to the central processing unit at established time intervals of between 0.5 and 0.15 seconds, preferably every 0.12 seconds. The data is processed, determining whether there is any variation in the magnetic field determined by the digital compass at any given time in the event of using said device of the module for determining the magnetic field. When the existence of a variation in the magnetic field is determined on the basis of a variation in the data received by the monitoring module it is considered that there is an interference in the magnetic field that surrounds the device and, therefore, it is considered that there is a metal near or close to said device; the position of the element that generated the interference, the metal, can be determined based on the data received, which are data relating to the measurement of the variation in the magnetic field, as each change in position has been monitored, enabling determination of the direction in which the magnetic field has changed and, thus, the origin of the interference.

### DESCRIPTION OF THE DRAWINGS

In order to complement the description being made and with the object of helping to better understand the characteristics of the invention, in accordance with a preferred embodiment thereof, said description is accompanied, as an integral part thereof, by a set of drawings where, in an illustrative and non-limiting manner, the following has been represented:

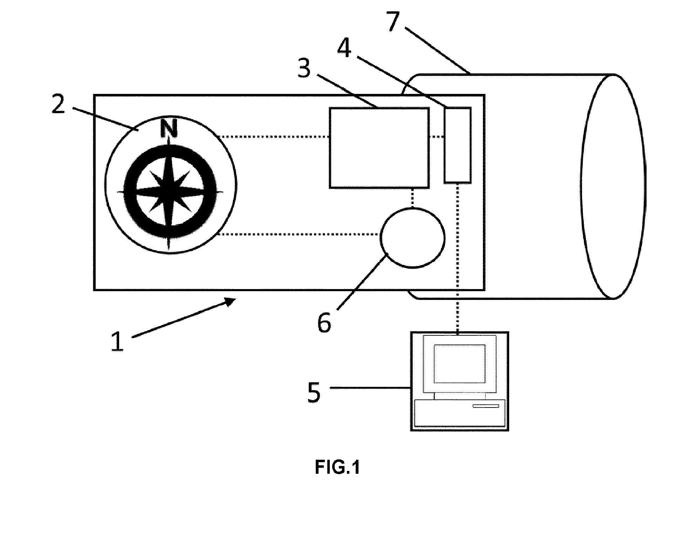

Figure 1 shows a schematic view of the device object of the invention.

### PREFERRED EMBODIMENT OF THE INVENTION

In light of the figures, following is a description of a preferred embodiment of the device (1) object of this invention.

As can be observed in figure 1, the metal detection device (1) object of the invention described herein has a series of elements, a determining module (2) and a monitoring module (3) which are integrated in a PCB, wherein said device (1) enables, by determining the variations in the magnetic field that surrounds the device (1) generated by interferences produced by metallic bodies, the detection of said metallic bodies. Said modules (2, 3) are housed inside a preferably cylindrical casing (7) destined for housing at least the modules (2, 3) in its interior.

In a preferred embodiment of the device (1) wherein the device may be autonomous, it comprises a power supply module (6) connected to the modules (2, 3) destined for supplying energy to said modules (2, 3) and, if necessary, also to data transmission means (4), and a power supply module (6) defined by an autonomous battery integrated in the device itself (1); while in an alternative embodiment the power supply module (6) is a source of electric current such as a central battery, connected to the device (1) by means of a cable that supplies power thereto.

Another aspect of the invention consists of a system of several devices (1), i.e. a metal detection system comprising a plurality of devices (1) interconnected by means of 485-type cabling, aligned and interconnected so as to form a cordon of devices (1). This system can have a power supply (6) defined by a battery connected to at least one of the devices (1) which is disposed at the ends of the cordon of devices (1) or defined by a connection to a power grid connected to at least one of the devices (1). Although this device (1) whereto the power grid is connected can be any of the devices of the system, it will preferably be one of the devices disposed at the ends of the cordon of devices (1).

The operating mode of the invention can be explained as follows: a device (1) is installed in an area where there are no metallic objects or bodies that could interfere with the magnetic field; next, the module for determining the magnetic field (2) starts determining whether there is any variation in the magnetic field, said module being destined for determining at least one variable related to the magnetic field that surrounds the device (1); in a preferred embodiment of the invention, said module for determining the magnetic field (1) is a compass (preferably digital) destined for indicating a possible variation in the magnetic field; said variable is related to the magnetic field that surrounds the device (1), although any electronic device sensitive to magnetic fields can also be useful for performing this function; once said determining module (2) establishes data relating to said possible variation in the magnetic field, the device can be considered to be ready to start detecting metals; once said determining module (2) has established the data relating to said possible variation in the magnetic field, it can be considered that the device is ready to start detecting metals; after the determining module (2) has generated the data relating to said variation in the magnetic field, wherein said data is processed by electronic devices and comprise information relating to the magnetic field that surrounds the device (1), said data relating to said magnetic field are monitored by the module for monitoring the magnetic field (3) connected to the module for determining the magnetic field (2) destined for monitoring changes in the variable related to the magnetic field that surrounds the device (1) determined by the determining module (2); the monitoring module (3), which in turn comprises the data transmission means (4) destined for establishing a communication channel for transmitting data with said monitoring module (3), comprises a programmable device adapted to check the indication of variation in the magnetic field determined by the module for determining the magnetic field (2) every 0.12 seconds, generating data relating to variations in the magnetic field every aforementioned time interval and which is connected, through the data transmission means (4), to at least one central processing unit (5), whereto it sends the data relating to variations in the magnetic field.

Said data is sent to a central processing unit (5) via the data transmission means (4). In a preferred embodiment in which there is only one device (1), said data transmission means (4) can be defined by a 3G or GPRS modem, but in other configurations or possible alternative embodiments said data transmission means (4) can be defined by other types of wireless communication such as WIFI or Bluetooth or Zigbee, or by cable-based communication means such as 485-type cable with its corresponding buses.

Once said data have been received, the presence of a metal is determined when a variation in the magnetic field is determined by means of a central processing unit (5). Said variation is determined in accordance with variations in the magnetic field based on the data sent.

## Claims

1. A metal detection device (1), **characterised in that** it comprises:
• at least one determining module (2) for determining the magnetic field and adapted for determining at least one variable related to the magnetic field that surrounds the device (1); and
• at least one monitoring module (3) for monitoring the magnetic field connected to the determining module (2) and adapted for monitoring variations in the variable related to the magnetic field that surrounds the device (1) determined by the determining module (2), said monitoring module (3) comprising in turn data transmission means (4) adapted for establishing a communication channel for transmitting data with the aforementioned monitoring module (3).

2. A device (1), according to claim 1, **characterised in that** it also comprises a power supply module (6) connected to the modules (2, 3) adapted for supplying power to said modules (2, 3).

3. A device (1), according to claim 1 or 2, **characterised in that** the two modules (2, 3) are integrated in a PCB.

4. A device (1), according to any one of claims 1 to 3, **characterised in that** the module for determining the magnetic field (1) is a digital compass adapted for indicating the existence of a variation in the magnetic field, said variable being related to the magnetic field that surrounds the device (1).

5. A device (1), according to claim 4, **characterised in that** the monitoring module (3) comprises a programmable device adapted to check the indication of the variation in the magnetic field determined by the module for determining the magnetic field (2) every 0.12 seconds, generating data related to the variation in the magnetic field every aforementioned time interval.

6. A device (1), according to claim 5, wherein the monitoring module (3) is connected through the data transmission means (4) to at least one central processing unit (5) to send data relating to the position of the variation in the magnetic field to said one central processing unit (5).

7. A device (1), according to claim 1, **characterised in that** the data transmission means (4) are selected from among the group consisting of: a WIFI wireless communication module, a GPRS modem wireless communication module and cable-based transmission means.

8. A device (1), according to claim 7, **characterised in that** the cable-based transmission means are defined by a 485-type bus cable connection.

9. A device (1), according to any one of the preceding claims, **characterised in that** it comprises a preferably cylindrical casing (7) adapted for housing at least the modules (2, 3) in its interior.

10. A device (1), according to claim 2, **characterised in that** the power supply module (6) connected to the modules (2, 3) adapted for supplying power to the aforementioned modules (2, 3) is defined by an autonomous battery integrated in the device itself (1).

11. A metal detection system, **characterised in that** it comprises a plurality of devices (1) such as that described in claims 1 to 9 interconnected by 485-type cable, aligned and interconnected, forming a cordon of devices (1).

12. A system, according to claim 11, **characterised in that** the power supply module (6) is defined by a battery connected to at least one of the devices (1) disposed at the ends of the cordon of devices (1).

13. A system, according to claim 11, **characterised in that** the power supply module (6) is defined by a connection to an electricity supply network connected to at least one of the devices (1) disposed at the ends of the cordon of devices (1).

14. A metal detection method that uses at least one device (1) such as that described in claims 1 to 10, said method being **characterised in that** it comprises the following steps:
• determining a variation in the magnetic field by means of the determining module (2);
• generating data relating to said position of the variation in the magnetic field by means of the determining module (2), wherein said data can be managed by electronic devices and comprise information relating to the relative position of the variation in the magnetic field;
• monitoring said data relating to the variation in the magnetic field;
• sending said data to the one central processing unit; (5); and
• determining, by means of the central processing unit (5), the presence of a metal when a variation in the magnetic field is determined, said variation being determined in accordance with variations in the data relating to said variation in the magnetic field based on the data sent.

15. A method, according to claim 14, wherein the determination of the data relating to said position is performed by the monitoring module (3) every 0.12 seconds.
